# EUROPEAN PATENT SPECIFICATION

(11) **EP 4 307 716 B1**
(45) Date of publication and mention of the grant of the patent: **02.07.2025**
(21) Application number: 22185233.8
(22) Date of filing: 15.07.2022
(51) Int. Cl.: H04R 19/04, B81B 3/00

(54) **ROBUST MEMS DEVICE AND METHOD FOR MANUFACTURING A MEMS DEVICE**
ROBUSTE MEMS-VORRICHTUNG UND VERFAHREN ZUM HERSTELLEN EINER MEMS-VORRICHTUNG
DISPOSITIF MEMS ROBUSTE ET PROCÉDÉ DE FONCTIONNEMENT D'UN DISPOSITIF MEMS

(43) Date of publication of application: 17.01.2024
(73) Proprietor: Infineon Technologies AG, 85579 Neubiberg (DE)
(72) Inventor: Barzen, Stefan, 81671 München (DE); Frey, Alexander, 93138 Lappersdorf (DE); Herrmann, Matthias Friedrich, 81737 München (DE); Ooi, Jun Cheng, 11700 Gelugor Pulau Pinang (MY); Timme, Hans-Joerg, 85521 Ottobrunn (DE)
(74) Representative: Zimmermann, Tankred Klaus

(56) References cited:
- US-A1- 2015 001 647
- US-A1- 2015 245 118
- US-A1- 2015 358 735
- US-A1- 2020 239 302
- US-A1- 2021 044 905

## Description

The present disclosure relates to a MEMS device and to a method for fabricating such a MEMS device. The present disclosure in particular relates to a silicon microphone with a membrane to enhance robustness of the membrane by creating the membrane with locally different thicknesses.

Sensors with moving structures such as membranes are facing more or less the same issue. The membranes need to achieve a sufficient sensitivity to detect low signal levels, therefore have to be sufficiently moveable. On the other hand, it has to be sufficiently robust against forces exceeding the standard operation conditions, e.g., a drop or pressure burst.

US 2021/044905 A1 relates to a MEMS device that includes a flexible membrane disposed over a substrate, and a first backplate disposed over the flexible membrane.

US 2015/245118 A1 relates to a digital loudspeaker and a method for operating a digital loudspeaker.

US 2020/239302 A1 relates to a production method for a double-membrane MEMS component that includes: providing a layer arrangement on a carrier substrate.

US 2015/001647 A1 relates to a MEMS microphone that includes a first diaphragm element, a counter electrode element, and a low pressure region between the first diaphragm element and the counter electrode element.

There may be a need for sensitive and robust sensors.

According to an embodiment, a MEMS device comprises a first membrane structure, wherein the first membrane structure comprise a reinforcement region, wherein the reinforcement region has a larger thickness than an adjoining region of the first membrane structure. The MEMS device comprises an electrode structure, wherein the electrode structure is vertically spaced apart from the first membrane structure. The first membrane structure comprises a deflectable region and a clamped border region, wherein the clamped border region adjoins the deflectable region along a borderline of the deflectable region, wherein the reinforcement region of the first membrane structure is arranged at the borderline. Alternatively or in addition, the MEMS device comprises a second membrane structure, wherein the electrode structure is arranged between the first and second membrane structures, wherein the first and second membrane structures each comprise a deflectable portion, and wherein the deflectable portions of the first and second membrane structures are mechanically coupled by means of at least one mechanical connection element to each other and are mechanically decoupled from the electrode structure; wherein at least one of the first and second membrane structure comprises a reinforcement region at a coupling position with the at least one mechanical connection element.

A method for manufacturing such a MEMS device comprises manufacturing the reinforcement region of the first membrane structure using a local-Oxidation-of-Silicon, LOCOS, and arranging the electrode structure vertically spaced apart from the membrane structure. The method is executed such that the first membrane structure comprises a deflectable region and a clamped border region, such that the clamped border region adjoins the deflectable region along a borderline of the deflectable region, such that the reinforcement region of the first membrane structure is arranged at the borderline; or such that the MEMS device comprises a second membrane structure, wherein the electrode structure is arranged between the first and second membrane structures, such that the first and second membrane structures each comprise a deflectable portion, and wherein the deflectable portions of the first and second membrane structures are mechanically coupled by means of at least one mechanical connection element to each other and are mechanically decoupled from the electrode structure; and such that at least one of the first and second membrane structure comprises a reinforcement region at a coupling position with the at least one mechanical connection element.

Further embodiments are described in the dependent claims.

Embodiments in accordance with the present disclosure are described herein whilst making reference to the accompanying drawings in which:
- Fig. 1: is a schematic side view of a single-membrane MEMS device according to an embodiment;
- Fig. 2a: shows a schematic side view of a MEMS device according to an embodiment that comprises a layered electrode structure;
- Fig. 2b: shows a schematic side view of a inner section of a realization of MEMS device of Fig. 2a;
- Fig. 2c: shows a schematic side view of an outer section of a realization of MEMS device of Fig. 2a;
- Fig. 3: shows a schematic side view of an example MEMS device according to an embodiment having two membrane structures sandwiching an electrode structure; and
- Fig. 4a-e: show schematic side views of structures that may be obtained when performing a method in accordance with embodiments.

Equal or equivalent elements or elements with equal or equivalent functionality are denoted in the following description by equal or equivalent reference numerals even if occurring in different figures.

In the following description, a plurality of details is set forth to provide a more thorough explanation of embodiments of the present disclosure. However, it will be apparent to those skilled in the art that embodiments of the present disclosure may be practiced without these specific details. In other instances, well known structures and devices are shown in block diagram form rather than in detail in order to avoid obscuring embodiments of the present disclosure. In addition, features of the different embodiments described hereinafter may be combined with each other, unless specifically noted otherwise.

Embodiments described herein are related to microelectromechanical system (MEMS) devices. A MEMS device may comprise one or more semiconductor materials, for example an at least partially doped or undoped semiconductor material such as silicon, gallium arsenide or the like and/or combinations thereof. Materials derived therefrom such as silicon nitride (SiN, Si₃N₄, respectively), silicon oxide (SiOx, SiO₂, respectively) or the like may be arranged alternatively or in addition. Alternatively or in addition, other materials such as a metal material, e.g., aluminum, copper, gold, silver, platinum or the like may be part of a MEMS structure.

Embodiments described herein relate to a membrane structure. Such a membrane structure may be a beam-like membrane or a more circular structure, e.g., a round or circular membrane, a quadratic membrane structure or a rectangular membrane structure. A beam-like membrane may differ from a conventional (e.g. circular) membrane with respect to its boundary conditions. For example, a circular membrane may be clamped at its edge or perimeter, whereas a beam-like membrane may comprise some free edges. A membrane structure described herein may be formed, for example, similar to a membrane structure being used in the MEMS microphones or MEMS loudspeakers. A membrane structure described herein is deflectable in a deflectable region or portion thereof.

Some of the embodiments described herein are explained in connection with MEMS devices that may implement at least a part of a MEMS microphone. However, embodiments described herein are not limited to MEMS microphones. The described principles may be applied, without limitations, to other MEMS sensors and/or actuators. For example, a MEMS sensor may be implemented as a pressure sensor or other type of sensor. An actuator may, for example, provide at least for a part of a loudspeaker, a pump or the like, comprising a membrane. That is, one aspect of embodiments described herein relate to sound transducers such as microphones or loudspeakers whilst other types of sensors and/or actuators using a membrane for operation may also benefit from the described principles.

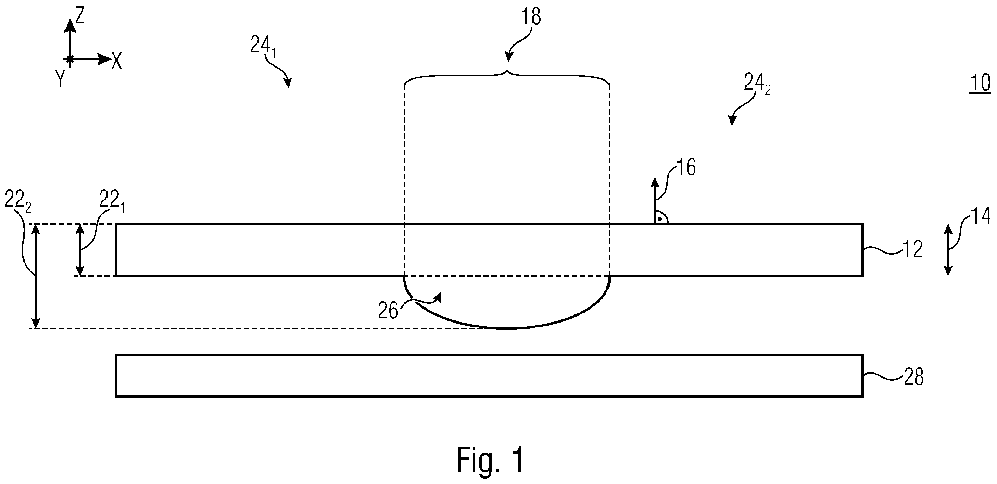

Fig. 1 is a schematic side view of a MEMS device 10 according to an embodiment. The MEMS device 10 comprises a membrane structure 12 being configured for deflecting along a direction 14 which may be, at least within a tolerance range, be in parallel with a surface normal 16 of the membrane structure 12, the surface normal 16 being perpendicular to one or both lateral extension directions. For example, the membrane structure 12 may be arranged so as to extend along lateral directions x and y whilst a thickness of the membrane structure may be arranged perpendicular hereto along a z-direction of an example Cartesian coordinate system. The direction 14 along with the membrane structure 12 may be flagged may, thus, be perpendicular to the z-direction as is the surface normal 16.

The membrane structure 14 may comprise a reinforcement region 18 which may be understood as a part of the extension of the membrane structure 12 along the lateral directions x and/or y. In the reinforcement region 18 the membrane structure 12 may comprise a larger layer thickness 22₂ when compared to an adjoining region 24₁ and/or 24₂ of the membrane structure 12 having a layer thickness 22₁.

An increase of the layer thickness 22₂ when compared to the layer thickness 22₁ may be larger or even significantly larger when compared to manufacturing tolerances that might provide for variances in the range of e.g., 1%, 2% or 5%. For example, the layer thickness 22₁ may be in a range of at least 10 nm and at most 10 µm, at least 20 nm and at most 5 µm or at least 100 nm and at most 1 µm, for example, around 315 nm. Compared hereto, the layer thickness 22₂ may be increased by at least 20%, at least 50%, at least 80% or even more. For example, the layer thickness of 315 nm may be increased to at least 400 nm and at most 2 µm, at least 500 nm and at most 1.5 µm or at least 600 nm and at most 1 µm, e.g., 760 nm.

The layer thickness 22₂ may relate to a maximum value of the layer thickness inside the reinforcement region 18, e.g., in case a continuous variation of the layer thickness if increased along the x and/or y- direction. A shape of the membrane with regard to the increase may also be discontinuous, e.g., formed as a kind of square or brick wall or the like.

The reinforcement region 18 may be formed by material being same or different from a material of the membrane structure 12. For example, it may be formed from one piece with the membrane structure 12, i.e., it may be integrally formed with the membrane structure 12. However, other ways of mechanically connecting additional reinforcing material 26 in the of the reinforcement region 18 to material of the membrane structure 12 during deposition of, e.g., the membrane structure onto the reinforcing material 26 or the reinforcing material 26 onto the membrane structure may be implemented, e.g., based on the used deposition process.

For example, arranging the additional material 26 at the membrane structure 12 or vice versa may be obtained by arranging or depositing the additional material 26 to increase the layer thickness 22₂ in the reinforcement region when compared to the adjoining regions 24. The additional material 26 may be arranged, e.g., by using an additional process or process step to attach the material 26 at the membrane structure 12, such an additional step may be executed prior or after providing the membrane. Alternatively or in addition, material may be locally removed from the membrane structure 12, e.g., in the adjoining regions 24₁ and/or 24₂ such that the material 26 may form, at least in parts, a remains of such a process. Alternatively or in addition, the membrane structure 12 may be formed so as to comprise the material 26 and the reinforcement region, e.g., by use of a deposition process or the like that deposits more material in the reinforcement region when compared to the adjoining regions 24₁ and/or 24₂.

The MEMS device 10 comprises an electrode structure 28 that is vertically spaced apart from the membrane structure 12. As a spacing vertically apart from the membrane structure 12 it may be understood to have a distance along the direction of deflection 14 between the membrane structure 12 and the electrode structure 28. The membrane structure 12 and the electrode structure 28 may overlap, at least in part, when being projected into a plane parallel to the x/y-direction. The electrode structure 28 may be understood as a backplate structure, e.g., when the MEMS device 10 forms a part of a MEMS microphone. The electrode structure 28 may be of a same or a different size along the x, y and/or z- direction when compared to the membrane structure 12.

The membrane structure 12 may be formed at least locally electrically conductive to allow application of an electrical potential between the membrane structure 12 and the electrode structure 28 that may provide for a basis for operating the MEMS device 10 as a sensor and/or an actuator.

The reinforcement region 18 may allow to combine different requirements being imposed on a membrane structure by using a single configuration. Whilst using a comparatively thin membrane in the adjoining region 24₁ and/or 24₂, a high compliance may be achieved that may allow for small chip areas and/or small extensions of the membrane in the x/y-direction. At a same time, the reinforcement region may allow for a high compliance by providing a high robustness of the membrane structure. According to an embodiment, the reinforcement region is arranged at a location or position of the membrane structure 12 which is subjected to a locally increased mechanical stress during an operation condition of the MEMS device 10, during an overload condition of the MEMS device and/or a misuse condition of the MEMS device. For example, where it is expected or possible to face high mechanical loads at the membrane structure 12, the membrane may locally be reinforced to avoid damages.

Such locations may be arranged at areas where the membrane is configured or expected to abut other structures or to face high stresses due to bending and/or stretching.

The membrane structure 12 may comprise a single or a multitude of reinforcement areas 18. Implementing a multitude of reinforcement regions 18 at the membrane structure 12 may allow for using a same layer thickness 22₂ for some or all of the reinforcement regions but may also to deviate with regard to the implemented layer thickness along different reinforcement regions.

Although being illustrated as facing the electrode structure 28, the reinforcement region may also be arranged at a side of the membrane structure 12 facing away from the electrode structure 28.

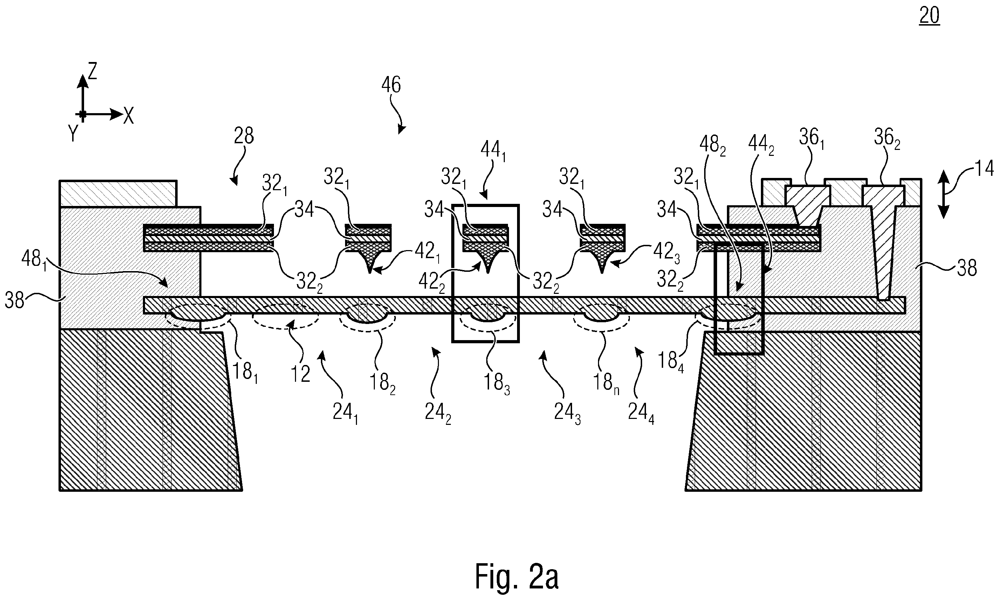

Fig. 2a shows a schematic side view of a MEMS device 20 according to an embodiment. The MEMS device 20 may comprise a layered electrode structure 28 that may have one or more insulating layers 32₁ and/or 32₂ and/or at least one conductive layer 34 that may be contacted by an electrical contact 36₁ to apply and/or receive an electrical potential.

The membrane structure 12 may comprise one or a plurality of n reinforcement regions 18₁ to 18ₙ. Parameter n may be a value of at least 1, at least 2, at least 5, at least 10, at least 100 or even 1000 or more. For example, reinforcement region 18₁ and/or 18₄ may be arranged in an area at which the membrane structure 12 is clamped or configured to abut a supporting structure 38, e. g., a substrate or the like. The membrane structure 12 may be electrically connected via an electrical contact 36₂ which may allow to obtain and/or sense a potential difference between electrical contacts 36₁ and 36₂.

Reinforcement regions 18₂, 18₃ and/or 18ₙ may be arranged at a location of an elevation or bump 42₁ to 42₃ or other structures that are adapted to provide a mechanical contact or an abutting region for the membrane structure 12 so as to reinforce the mechanical structure of the membrane structure 12 at this location. That is, when projecting elevation or bumps 42₁ to 42₃, they may overlap, partially or completely, with reinforcement regions 18₂, 18₃, 18ₙ, respectively. Although not necessarily implemented in such a way, at least one of elevation or bumps 42₁ to 42₃ may serve as an anti-stiction bump.

Clamping or abutting regions at the reinforcement regions 18₁ and 18₄ are examples for critical locations as are the reinforcement regions 18₂, 18₃ and 18ₙ that are expected to be subjected to a locally increased mechanical stress. Such a locally increased mechanical stress may occur during an operation condition as well as an overload condition or a misuse condition, e.g., dropping the device or mechanically overloading the device. The MEMS device 20 shows a comparatively thick membrane at such critical locations to increase robustness at those regions and may show a comparatively thin membrane in other regions to increase sensitivity or maintain a high sensitivity. This may incorporate to skip a corrugation. Adjoining regions 24₁ to 24ⱼ may be arranged adjacent to the reinforcement regions. However, the adjoining regions 24₁ to 24ⱼ may be connected to one another at least partly or may form a common adjacent region, e.g., in a case where one or more of the reinforcement regions 18₁ to 18ₘ is formed as an island structure or the like.

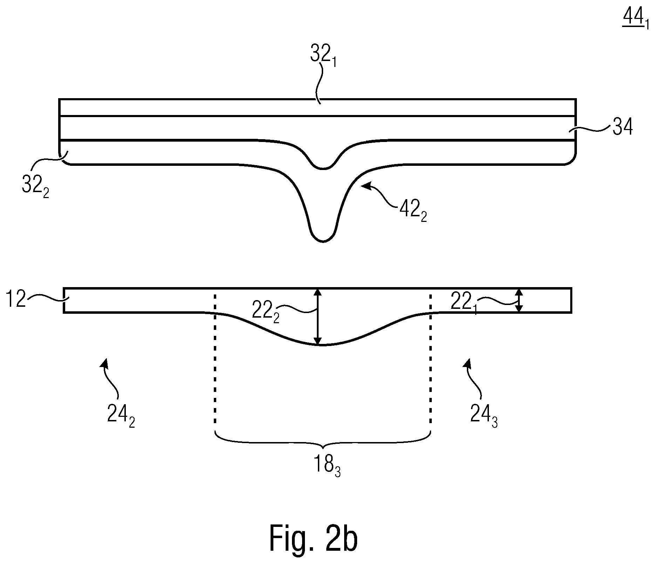

Fig. 2b shows a schematic side view of an implementation of MEMS device 20, in particular, a section 44₁ thereof. Fig. 2b shows insulating layers 32₁ and 32₂ sandwiching conductive layer 34 and anti-stiction bump 42₂. As may be seen in Fig. 2b, the reinforcement region 18₃ of the membrane structure 12 may be arranged in a position aligned with respect to a bump or elevation arranged at the electrode structure 28. Such a bump or elevation 42₂, e.g., an anti-stiction bump, may in addition or as an alternative be arranged at the membrane structure 12. For example, at a side opposing such a bump or elevation, the reinforcing material may be arranged so as to form the reinforcement region. This does not prevent to have the additional material of the reinforcement region at a same side as the bump or elevation. In the example shown in Fig. 2b, the bump or elevation, i.e., the anti-stiction bump 42₂ may be oriented towards the membrane structure 12. As is also illustrated in Fig. 2b, the reinforcement region 18₃ may be arranged to comprise a gradual or stepless transition of the layer thickness 22 to the adjoining region 24₂ and/or 24₃. According to other implementations the transition may comprise a step, i.e., a steep or transient transition.

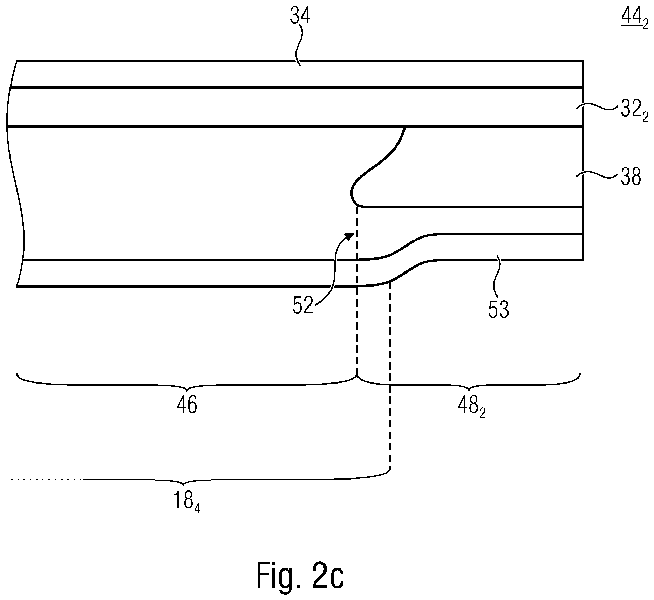

When referring back again to Fig. 2a, a section 44₂ thereof is shown by way of a schematic side view of a realization of such a structure in Fig. 2c. whilst the section 44₁ represents at least a part of a deflectable region 46 of the membrane structure 12, section 44₂ may be considered as a clamped border region 48 that adjoins the deflecting region 44₁. Between the deflectable region 46 and clamped regions 48₁ and 48₂ there may be representable a borderline 52. The clamped border region 48 may adjoin the deflectable region 46 along the borderline 52 of the deflectable region 46. The reinforcement region 18₄ is arranged at the borderline, i.e., to overlap the borderline that indicates a region of increased mechanical stress. An optional layer 53 shown in Fig. 2c the bright layer in 2c may be at least a part of a sacrificial layer, e.g., comprising an oxide. The layer 53 may be arranged at a position possibly below the membrane 12. In the region overlapping the moveable membrane 12 the layer 53 may be etched away. Alternatively or in addition, in a region where the membrane 12 is affixed, the layer 53 may remain.

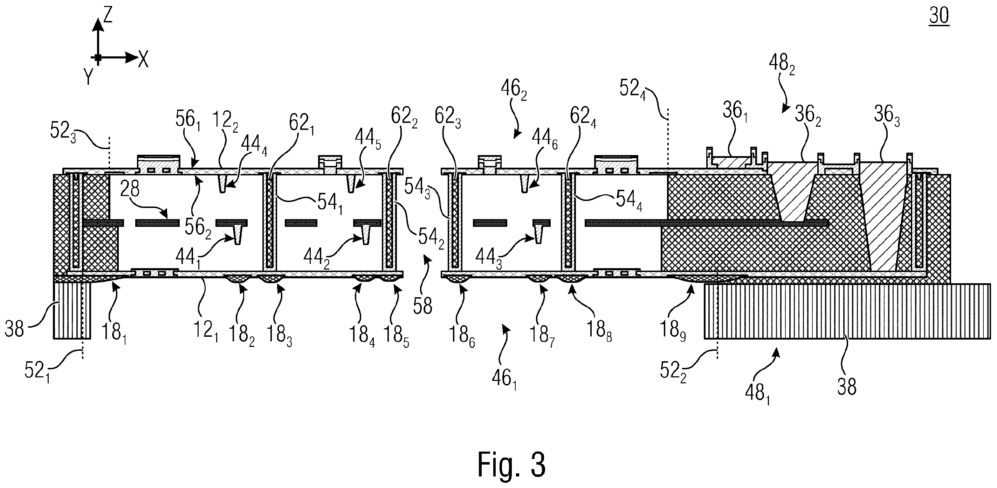

Fig. 3 shows a schematic side view of an example MEMS device 30 according to an embodiment. Whilst the MEMS device 20 may realize, for example, a single backplate sound transducer with a single membrane structure, MEMS device 30 may implement a sealed dual membrane, SDM, device. Such a device may comprise a membrane structure 12₁ and an opposing membrane structure 12₂ that may be spaced apart by mechanical connection elements 54₁ to 54₄, e.g., formed as pillar structures, and having the electrode structure 28 sandwiched therebetween. For example, the membrane structure 12₁ may be adapted to abut bump structures 44₁, 44₂ and/or 44₃ which may be addressed by implementing reinforcement regions 18₂, 18₄, 18₇, respectively. Alternatively or in addition, bump structures 44₄, 44₅ and/or 44₆ may be adapted to abut the electrode structure 28. Although not shown the membrane structure 12₂ may comprise reinforcement regions at corresponding locations on a side 56₁ and/or a side 56₂ thereof. Alternatively or in addition, reinforcement regions 18₃, 18₅, 18₆ and/or 18₈ may be arranged at membrane structure 12₁ and/or 12₂ at locations at which mechanical connection elements 54₁, 54₂, 54₃ and/or 54₄ are arranged on a same or opposing side of the respective electrode structure 12₁ and/or 12₂. Alternatively or in addition, reinforcement regions 18₁ and 18₉ may be implemented together or independent from one another in a region of borderlines 52₁ and/or 52₂.

Membrane structures 12₁ and 12₂ may be electrically connected to contacts 36₁ and/or 36₃. In a similar way, the electrode structure 28 may be electrically connected via electrical contact 36₂. Optionally, the MEMS device 30 may comprise one or more ventilation holes 58 to facilitate a movement of the membrane structures 12₁ and/or 12₂. According to an embodiment, a MEMS device such as MEMS device 30 may comprise, beside the first membrane structure, a second membrane structure wherein the electrode structure 28 may be arranged between the first and the second membrane structures 12₁ and 12₂. The membrane structures 12₁ and 12₂ may each comprise a deflectable portion or deflectable region 46₁, 46₂, respectively. The deflectable portions 46₁ and 46₂ may be mechanically connected or coupled by means of at least one mechanical connection element 54 to one another whilst being mechanically decoupled from the electrode structure 28. The deflectable region 46₂ and a clamped region 48₂ of the membrane structure 12₂ may be arranged so as to adjoin one another along borderlines 52₃ and/or 52₄.

Although not shown in Fig. 3, the membrane structure 12₂ may comprise one or more reinforcement regions also being formed as a single piece of the membrane structure 12₂. Such a reinforcement region may comprise a larger layer thickness than an adjoining region as was described in connection with membrane structure 12 in Fig. 1. According to an embodiment, the reinforcement region of membrane structure 12₂ may comprise a gradual or stepless transition of the layer thickness to the adjoining region. As was described in connection with membrane structure 12₁, the position of the membrane structure 12₂ is subjected to locally increased mechanical stress during an operation condition, an overload condition and/or a misuse condition of the MEMS device.

According to the invention the membrane structure 12₁ and/or 12₂ comprises a reinforcement structure or local stiffening 62 that is arranged at a coupling position at which the membrane structure is connected to at least one mechanical connection element 54 and/or in a region where the membrane structure 12₂ is clamped, e.g., at the borderline 52₃. The reinforcement structure 62₁, 62₂, 62₃ and/or 62₄ may comprise, for example, a material that has a higher stiffness when compared to a material of the membrane structure itself. For example, a material such as silicon nitride or the like may be used to reinforce a silicon-based membrane structure. Such a material may allow to use a material that is used for insulating one or more regions.

Respective reinforcement regions being not shown in Fig. 3 may, as was described in connection with MEMS device 10 and/or 20, be arranged in a position aligned with respect to a bump or elevation arranged at the electrode structure and/or at the membrane structure 12₂. Such a bump or elevation, e.g., an anti-stiction bump, on the electrode structure 28 may be orientated towards the membrane structure 12₂.

Reinforcement regions 18₁ and/or 18₉ that may be adapted to abut supporting structure 38 may be formed according to a hill-like structure but may, as an alternative, be formed like a donut-like structure, e.g., having a reduced thickness or being even absent in a center region or inner section, e.g., so as to host therein an edge of the supporting structure 38 abutting the reinforcement region.

A reinforcement region 18₁ to 18₉ may have a larger extension along the x-direction and/or y-direction when compared to the structure forming the source of the stress to be compensated for. For example, an elevation or bump such as bump 44₁, 44₂ and 44₃ may provide for a comparatively small surface abutting the membrane structure 12₁. This may allow an extension or diameter of reinforcement regions 18₂, 18₄ and/or 18₇ of, e.g., 2 µm, 3 µm, 4 µm or other suitable values to be sufficient, e.g., applying a factor of 1, 2, 3 or more to the extension of the source of stress.

An extension of coupling structures 62 being, for example, around 2 µm along the x-direction may be compensated by use of a reinforcement region 18₃, 18₅ and/or 18₈ that has a same, two times, three times or four times or more of said dimension, e.g., in a range between 6 µm and 8 µm.

On the other hand, tolerances during manufacturing and/or operation may lead to uncertainties and/or larger areas of stress generation which may be addressed by implementing a large area of the respective reinforcement region. On the other hand, for example, an edge of a supporting structure 38 may be generated by use of an etching process such that an etched edge is inclined with regard to the z-direction. For example, this may come along with a tolerance of plus minus 20 µm and an extension of the reinforcement region 18₉ having, e.g., a double of said size or, e.g., 40 µm, may allow to compensate for such tolerances.

When considering the membrane structure 12₁ and/or 12₂ as a rectangular, round or oval structure, the reinforcement region 18₁ and 18₉ may also form a combined, segmented or uniform reinforcement region, e.g., having a circular or oval shape.

According to embodiments, the respective reinforcement region is at least of a same size when compared to the structure causing the stress to be compensated. According to other embodiments, the reinforcement region is larger, e.g., having a size of factor 2, 3, 4 or more.

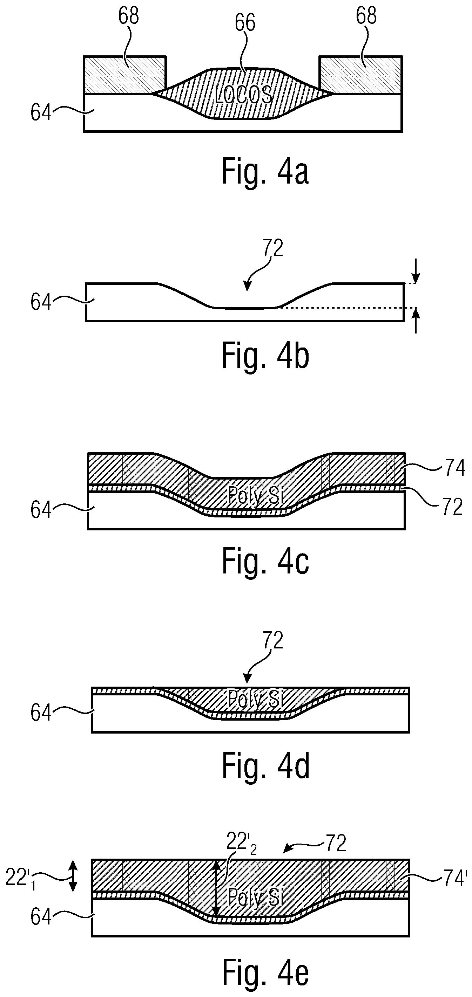

One possible implementation to produce or obtain the varying layer thickness of the membrane structure 12 of a MEMS device 10 and/or 20 or the membrane structure 12₁ of MEMS device 30 is explained whilst making reference to a method being illustrated in Figs. 4a - 4e.

Fig. 4a shows a step of local oxidation, e.g., performing a local oxidation of a substrate 64 which may comprise, for example, a silicon material. Such a step may be considered as local oxidation of silicon (LOCOS) to obtain an oxide material 66 by at least partly oxidizing the substrate 64, e.g., using a mask 68.

By removing the oxide material 66 as shown in Fig. 4b, a recess 72 may be obtained that may have a depth of, for example, at most or in a range of 1 µm, , e.g., at least 10 nm, at least 100 nm or at least 300 nm, e.g., 500 nm or a different value below 1 µm or about 1 µm.

Fig. 4c shows an example of further processing the substrate 64 of Fig. 4b by performing a deposition of Tetraethylorthosilicate (TEOS - e.g., C₈H₂₀O₄Si) and a deposition of, e.g., an oxide layer 72, e.g., silicon-oxide SiO₂, followed by a deposition of a semiconductor layer 74 such as a silicon layer, in particular, a poly-silicon layer.

As shown Fig. 4d, a planar surface may be obtained, for example, by using a chemical-mechanical polishing, CMP, process e.g., to remove at least a part of the layer 74 outside region 72 that may later form the reinforcement region 18. Using this planarized surface, a same material as layer 74 may be deposited again to increase the layer thickness homogeneously to obtain a varying thickness in the region 72 and outside thereof.

The step illustrated in Fig. 4e may be used to deposit again polysilicon and may allow to afterwards continue with standard processes to mount or use the obtained membrane structure. A process containing the steps as illustrated in Figs. 4a - 4e may be referred to as a locally thicker membrane (LTM) process. Such a process may be used for single backplate devices as well as sealed dual membrane devices. Although describing the membrane structure 12, 12₁ and/or 12₂ as being deflectable, such a feature is not mandatory. Also undeflected structures may benefit from a reinforcement region. A locally reinforcement may provide for an improvement of robustness whilst providing for a high sensitivity. By using a locally thicker membrane, a stress being introduced in the reinforced structure may be distributed so as to allow for a uniform stress distribution or at least a more uniform stress distribution.

As shown by Figs. 4a - 4e, a method for manufacturing a MEMS device in accordance with embodiments described herein comprises manufacturing the reinforcement region of the membrane structure using a LOCOS process. Alternatively or even in combination, an etching process to obtain tapered edges of an etched recess at the reinforcement region may be used for manufacturing the reinforcement region. Such edges may be inclined with respect to a surface normal of a main surface of the membrane structure 12₁ and/or 12₂. For example, such an etching process may comprise a wet silicon oxide (SiO) etching with tapered edges, e.g. by damaging an implant and/or by using a doped oxide. Such an etching process may be implemented with low effort when compared to the LOCOS process, e.g., in a case where a structure such as membrane structure 12₂ of MEMS device 30 is hard or even unable to be processed with the LOCOS process. Further, not shown in Figs. 4a - 4e, a method may comprise arranging the electrode structure 28 vertically spaced apart from the membrane structure. As shown in Figs. 4a - 4e, a method may additionally comprise a step of oxide etching, Fig. 4b, a deposition of reinforcement material (TEOS, SiON/silicon oxide/silicon nitride, poly-Si), Fig. 4c, a planarization (CMP), Fig. 4d and/or a standard deposition of a membrane material, Fig. 4e.

A method in accordance with embodiments may be implemented to comprise arranging a second membrane structure in such a way that the electrode structure is arranged between the membrane structures 12₁ and 12₂ as shown in Fig. 3. Such a method may comprise manufacturing a reinforcement region of the second membrane structure 12₂ using a LOCOS process that may also be used to then insert material of a reinforcement structure 62. As an alternative or even in combination, an etching process that provides for edges of the obtained recess that are tapered or inclined with respect to a surface normal of the etched structure, may be used. According to an embodiment, different MEMS devices may be manufactured differently. For example, the MEMS device 20 may be manufactured using the LOCOS process or a described etching process. Although not precluding to use the LOCOS process for both membrane structures 12₁ and 12₂, a MEMS device having a double membrane structure such as MEMS device 30 may be manufactured by use of an etching process, e.g., at least for membrane structure 12₂ allowing a combination with the LOCOS process when using same for membrane structure 12₁ and/or allowing to use the etching process also for manufacturing the membrane structure 12₁. The reinforcement region 18 may be generated according to both options.

Embodiments provide, among other things, a membrane of a sensor that has a locally different thickness in order to achieve high robustness whilst maintaining sensitivity. Using the LOCOS process in the process flow for manufacturing a MEMS device such as a silicon microphone these different thicknesses can be achieved using standard CMOS (complementary metal oxide semiconductor) processes. Such a process flow may create a thickened structure with smooth transitions from the thicker to the thinner region and therefore may avoid high stress concentration at these points. This may be of relevance as for a membrane it may be at least to a certain extent or even mostly the thickness which determines together with the stress and the structure the sensitivity. Therefore, a thicker structure may be an aim to achieve robustness whilst a contradicting requirement may lead to a thin membrane to achieve high sensitivity. Embodiments allow to combine both aims whilst providing a solution.

Embodiments allow to provide for a reinforcement at regions where stress, e.g., due to an overload, that is not equally present in all positions of the membrane concentrates to avoid a failure of the device at those locations. A sensor membrane may be structured, according to an embodiment, in a way that it has locally a higher thickness to gain high robustness in the critical areas, where in the larger area of the membrane the thickness may be reduced or kept low to gain the wanted high sensitivity.

Although some aspects have been described in the context of an apparatus, it is clear that these aspects also represent a description of the corresponding method, where a block or device corresponds to a method step or a feature of a method step. Analogously, aspects described in the context of a method step also represent a description of a corresponding block or item or feature of a corresponding apparatus.

The above described embodiments are merely illustrative for the principles of the present disclosure. It is understood that modifications and variations of the arrangements and the details described herein will be apparent to others skilled in the art. It is the intent, therefore, to be limited only by the scope of the impending patent claims and not by the specific details presented by way of description and explanation of the embodiments herein.

## Claims

1. A MEMS device comprising:
a first membrane structure (12; 12₁), wherein the first membrane structure (12; 12₁) comprises a reinforcement region (18; 18₁-18₉), wherein the reinforcement region (18; 18₁-18₉) has a larger layer thickness (22₂) than an adjoining region (24; 24₁-24₂) of the first membrane structure (12; 12₁), and
an electrode structure (28), wherein the electrode structure (28) is vertically spaced apart from the first membrane structure (12; 12₁);
**characterized in that**:
the first membrane structure (12; 12₁) comprises a deflectable region (46; 46₁) and a clamped border region, wherein the clamped border region adjoins the deflectable region (46; 46₁) along a borderline of the deflectable region (46; 46₁), wherein the reinforcement region (18; 18₁-18₉) of the first membrane structure (12; 12₁) is arranged at the borderline; or
the MEMS device comprises a second membrane structure (12₂), wherein the electrode structure (28) is arranged between the first and second membrane structures(12₁-12₂), wherein the first and second membrane structures (12₁-12₂) each comprise a deflectable portion (46₁-46₂), and wherein the deflectable portions (46₁-46₂) of the first and second membrane structures (12₁-12₂) are mechanically coupled by means of at least one mechanical connection element (54₁-54₃) to each other and are mechanically decoupled from the electrode structure (28); wherein at least one of the first and second membrane structure (12₁-12₂) comprises a reinforcement region (18; 18₁-18₉) at a coupling position with the at least one mechanical connection element.

2. The MEMS device according to claim 1, wherein the reinforcement region (18; 18₁-18₉) of the first membrane structure (12; 12₁) is also arranged in a position aligned with respect to a bump (42₁-42₃) or elevation arranged at the electrode structure (28) or the first membrane structure (12; 12₁).

3. The MEMS device according to claim 2, wherein the bump (42₁-42₃) or elevation on the electrode structure (28) is oriented towards the first membrane structure (12; 12₁).

4. The MEMS device according to any of the preceding claims, wherein the reinforcement region (18; 18₁-18₉) of the first membrane structure (12; 12₁) is arranged to comprise a gradual or stepless transition of the layer thickness (22₂) to the adjoining region (24; 24₁-24₂) of the first membrane structure (12; 12₁).

5. The MEMS device according to any of the preceding claims , wherein the MEMS device comprises the second membrane structure (12₂), wherein the electrode structure (28) is arranged between the first and second membrane structures(12₁-12₂), wherein the first and second membrane structures (12₁-12₂) each comprise a deflectable portion (46₁-46₂), and wherein the deflectable portions (46₁-46₂) of the first and second membrane structures (12₁-12₂) are mechanically coupled by means of the at least one mechanical connection element (54₁-54₃) to each other and are mechanically decoupled from the electrode structure (28); wherein the second membrane structure (12₂) comprises a reinforcement region (18; 18₁-18₉), wherein the reinforcement region (18; 18₁-18₉) of the second membrane structure (12₂) has a larger layer thickness (22₂) than an adjoining region (24; 24₁-24₂) of the second membrane structure (12₂), and wherein the reinforcement region (18; 18₁-18₉) of the second membrane structure (12₂) is arranged to comprise a gradual or stepless transition of the layer thickness (22₂) to the adjoining region (24; 24₁-24₂) of the second membrane structure (12₂).

6. The MEMS device according to any of the preceding claims, wherein the MEMS device comprises the second membrane structure (12₂), wherein the electrode structure (28) is arranged between the first and second membrane structures(12₁-12₂), wherein the first and second membrane structures (12₁-12₂) each comprise a deflectable portion (46₁-46₂), and wherein the deflectable portions (46₁-46₂) of the first and second membrane structures (12₁-12₂) are mechanically coupled by means of the at least one mechanical connection element (54₁-54₃) to each other and are mechanically decoupled from the electrode structure (28); wherein the reinforcement region of the second membrane structure (12₂) is arranged in a position aligned with respect to a bump (44₄-44₆) or elevation arranged at the electrode structure (28) or the second membrane structure (12₂).

7. The MEMS device according to claim 6, wherein the bump or elevation on the electrode structure (28) is oriented towards the second membrane structure (12₂).

8. The MEMS device according to any of the claims 5 to 7, wherein the MEMS device comprises the second membrane structure (12₂), wherein the electrode structure (28) is arranged between the first and second membrane structures(12₁-12₂), wherein the first and second membrane structures (12₁-12₂) each comprise a deflectable portion (46₁-46₂), and wherein the deflectable portions (46₁-46₂) of the first and second membrane structures (12₁-12₂) are mechanically coupled by means of the at least one mechanical connection element (54₁-54₃) to each other and are mechanically decoupled from the electrode structure (28); wherein the second membrane structure (12₂) comprises a deflectable region (46₂) and a clamped border region (48₂), wherein the clamped border region (48₂) adjoins the deflectable region (46₂) along a borderline (52₄) of the deflectable region (46₂), wherein the reinforcement region (18; 18₁-18₉) of the second membrane structure (12₂) is arranged at the borderline (52₄).

9. A method for manufacturing the MEMS device according to any of the preceding claims, comprising
manufacturing the reinforcement region (18; 18₁-18₉) of the first membrane structure (12; 12₁) using a LOCOS process, Local-Oxidation-of-Silicon process, or using an etch process to obtain tapered edges of a recess, and
arranging the electrode structure (28) vertically spaced apart from the first membrane structure (12; 12₁);
characterized such that the first membrane structure (12; 12₁) comprises the deflectable region (46; 46₁) and the clamped border region, such that the clamped border region adjoins the deflectable region (46; 46₁) along the borderline of the deflectable region (46; 46₁), such that the reinforcement region (18; 18₁-18₉) of the first membrane structure (12; 12₁) is arranged at the borderline; or
such that the MEMS device comprises the second membrane structure (12₂), wherein the electrode structure (28) is arranged between the first and second membrane structures(12₁-12₂), such that the first and second membrane structures (12₁-12₂) each comprise the deflectable portion (46₁-46₂), and wherein the deflectable portions (46₁-46₂) of the first and second membrane structures (12₁-12₂) are mechanically coupled by means of the at least one mechanical connection element (54₁-54₃) to each other and are mechanically decoupled from the electrode structure (28); and such that at least one of the first and second membrane structure (12₁-12₂) comprises the reinforcement region (18; 18₁-18₉) at the coupling position with the at least one mechanical connection element.

10. The method according to claim 9, further comprising
arranging the second membrane structure (12₂) in such a way that the electrode structure (28) is arranged between the first and second membrane structures (12₁-12₂), and
manufacturing the reinforcement region of the second membrane structure (12₂) using a LOCOS process, Local-Oxidation-of-Silicon process, or using an etch process to obtain tapered edges of a recess.

## Patentansprüche

1. MEMS-Bauelement, das folgende Merkmale aufweist:
eine erste Membranstruktur (12; 12₁), wobei die erste Membranstruktur (12; 12₁) einen Verstärkungsbereich (18; 18₁-18₉) aufweist, wobei der Verstärkungsbereich (18; 18₁-18₉) eine größere Schichtdicke (22₂) als ein angrenzender Bereich (24; 24₁-24₂) der ersten Membranstruktur (12; 12₁) aufweist, und
eine Elektrodenstruktur (28), wobei die Elektrodenstruktur (28) vertikal von der ersten Membranstruktur (12; 12₁) beabstandet ist;
**dadurch gekennzeichnet, dass**:
die erste Membranstruktur (12; 12₁) einen auslenkbaren Bereich (46; 46₁) und einen eingespannten Grenzbereich aufweist, wobei der eingespannte Grenzbereich entlang einer Grenzlinie des auslenkbaren Bereichs (46; 461) an den auslenkbaren Bereich (46; 46₁) angrenzt, wobei der Verstärkungsbereich (18; 18₁-18₉) der ersten Membranstruktur (12; 12₁) an der Grenzlinie angeordnet ist; oder
das MEMS-Bauelement eine zweite Membranstruktur (12₂) aufweist, wobei die Elektrodenstruktur (28) zwischen der ersten und der zweiten Membranstruktur (12₁-12₂) angeordnet ist, wobei die erste und die zweite Membranstruktur (12₁-12₂) jeweils einen auslenkbaren Abschnitt (46₁-46₂) aufweisen, und wobei die auslenkbaren Abschnitte (46₁-46₂) der ersten und der zweiten Membranstruktur (12₁-12₂) mittels zumindest eines mechanischen Verbindungselements (54₁-54₃) mechanisch miteinander gekoppelt und von der Elektrodenstruktur (28) mechanisch entkoppelt sind; wobei zumindest eine der ersten und der zweiten Membranstruktur (12₁-12₂) einen Verstärkungsbereich (18; 18₁-18₉) an einer Kopplungsposition mit dem zumindest einen mechanischen Verbindungselement aufweist.

2. MEMS-Bauelement gemäß Anspruch 1, wobei der Verstärkungsbereich (18; 18₁-18₉) der ersten Membranstruktur (12; 12₁) auch in einer Position angeordnet ist, die in Bezug auf einen Höcker (42₁-42₃) oder eine Erhebung ausgerichtet ist, der bzw. die an der Elektrodenstruktur (28) oder der ersten Membranstruktur (12; 12₁) angeordnet ist.

3. MEMS-Bauelement gemäß Anspruch 2, wobei der Höcker (42₁-42₃) oder die Erhebung an der Elektrodenstruktur (28) in Richtung der ersten Membranstruktur (12; 12₁) ausgerichtet ist.

4. MEMS-Bauelement gemäß einem der vorhergehenden Ansprüche, wobei der Verstärkungsbereich (18; 18₁-18₉) der ersten Membranstruktur (12; 12₁) so angeordnet ist, dass er einen allmählichen oder stufenlosen Übergang der Schichtdicke (22₂) zu dem angrenzenden Bereich (24; 24₁-24₂) der ersten Membranstruktur (12; 12₁) aufweist.

5. MEMS-Bauelement gemäß einem der vorhergehenden Ansprüche, wobei das MEMS-Bauelement die zweite Membranstruktur (12₂) aufweist, wobei die Elektrodenstruktur (28) zwischen der ersten und der zweiten Membranstruktur (12₁-12₂) angeordnet ist, wobei die erste und die zweite Membranstruktur (12₁-12₂) jeweils einen auslenkbaren Abschnitt (46₁-46₂) aufweisen, und wobei die auslenkbaren Abschnitte (46₁-46₂) der ersten und der zweiten Membranstruktur (12₁-12₂) mittels des zumindest einen mechanischen Verbindungselements (54₁-54₃) mechanisch miteinander gekoppelt und von der Elektrodenstruktur (28) mechanisch entkoppelt sind; wobei die zweite Membranstruktur (12₂) einen Verstärkungsbereich (18; 18₁-18₉) aufweist, wobei der Verstärkungsbereich (18; 18₁-18₉) der zweiten Membranstruktur (12₂) eine größere Schichtdicke (22₂) als ein angrenzender Bereich (24; 24₁-24₂) der zweiten Membranstruktur (12₂) aufweist, und wobei der Verstärkungsbereich (18; 18₁-18₉) der zweiten Membranstruktur (12₂) so angeordnet ist, dass er einen allmählichen oder stufenlosen Übergang der Schichtdicke (22₂) zu dem angrenzenden Bereich (24; 24₁-24₂) der zweiten Membranstruktur (12₂) aufweist.

6. MEMS-Bauelement gemäß einem der vorhergehenden Ansprüche, wobei das MEMS-Bauelement die zweite Membranstruktur (12₂) aufweist, wobei die Elektrodenstruktur (28) zwischen der ersten und der zweiten Membranstruktur (12₁-12₂) angeordnet ist, wobei die erste und die zweite Membranstruktur (12₁-12₂) jeweils einen auslenkbaren Abschnitt (46₁-46₂) aufweisen, und wobei die auslenkbaren Abschnitte (46₁-46₂) der ersten und der zweiten Membranstruktur (12₁-12₂) mittels des zumindest einen mechanischen Verbindungselements (54₁-54₃) mechanisch miteinander gekoppelt und von der Elektrodenstruktur (28) mechanisch entkoppelt sind; wobei der Verstärkungsbereich der zweiten Membranstruktur (12₂) in einer Position angeordnet ist, die in Bezug auf einen Höcker (44₄-44₆) oder eine Erhebung ausgerichtet ist, der bzw. die an der Elektrodenstruktur (28) oder der zweiten Membranstruktur (12₂) angeordnet ist.

7. MEMS-Bauelement gemäß Anspruch 6, wobei der Höcker oder die Erhebung an der Elektrodenstruktur (28) in Richtung der zweiten Membranstruktur (12₂) ausgerichtet ist.

8. MEMS-Bauelement gemäß einem der Ansprüche 5 bis 7, wobei das MEMS-Bauelement die zweite Membranstruktur (12₂) aufweist, wobei die Elektrodenstruktur (28) zwischen der ersten und der zweiten Membranstruktur (12₁-12₂) angeordnet ist, wobei die erste und die zweite Membranstruktur (12₁-12₂) jeweils einen auslenkbaren Abschnitt (46₁-46₂) aufweisen, und wobei die auslenkbaren Abschnitte (46₁-46₂) der ersten und der zweiten Membranstruktur (12₁-12₂) mittels des zumindest einen mechanischen Verbindungselements (54₁-54₃) mechanisch miteinander gekoppelt und von der Elektrodenstruktur (28) mechanisch entkoppelt sind; wobei die zweite Membranstruktur (12₂) einen auslenkbaren Bereich (46₂) und einen eingespannten Grenzbereich (48₂) aufweist, wobei der eingespannte Grenzbereich (48₂) entlang einer Grenzlinie (52₄) des auslenkbaren Bereichs (462) an den auslenkbaren Bereich (46₂) angrenzt, wobei der Verstärkungsbereich (18; 18₁-18₉) der zweiten Membranstruktur (12₂) an der Grenzlinie (52₄) angeordnet ist.

9. Verfahren zum Herstellen des MEMS-Bauelements gemäß einem der vorhergehenden Ansprüche, das folgende Schritte aufweist:
Herstellen des Verstärkungsbereichs (18; 18₁-18₉) der ersten Membranstruktur (12; 12₁) unter Verwendung eines LOCOS-Prozesses, eines Lokale-Oxidation-von-Silizium-Prozesses, oder unter Verwendung eines Ätzprozesses, um spitz zulaufende Kanten einer Aussparung zu erhalten, und
Anordnen der Elektrodenstruktur (28) vertikal beabstandet von der ersten Membranstruktur (12; 12₁);
gekennzeichnet
derart, dass die erste Membranstruktur (12; 12₁) den auslenkbaren Bereich (46; 46₁) und den eingespannten Grenzbereich aufweist, derart, dass der eingespannte Grenzbereich entlang der Grenzlinie des auslenkbaren Bereichs (46; 461) an den auslenkbaren Bereich (46; 46₁) angrenzt, derart, dass der Verstärkungsbereich (18; 18₁-18₉) der ersten Membranstruktur (12; 12₁) an der Grenzlinie angeordnet ist; oder
derart, dass das MEMS-Bauelement die zweite Membranstruktur (12₂) aufweist, wobei die Elektrodenstruktur (28) zwischen der ersten und der zweiten Membranstruktur (12₁-12₂) angeordnet ist, derart, dass die erste und die zweite Membranstruktur (12₁-12₂) jeweils den auslenkbaren Abschnitt (46₁-46₂) aufweisen, und wobei die auslenkbaren Abschnitte (46₁-46₂) der ersten und der zweiten Membranstruktur (12₁-12₂) mittels des zumindest einen mechanischen Verbindungselements (54₁-54₃) mechanisch miteinander gekoppelt und von der Elektrodenstruktur (28) mechanisch entkoppelt sind; und derart, dass zumindest eine der ersten und der zweiten Membranstruktur (12₁-12₂) den Verstärkungsbereich (18; 18₁-18₉) an einer Kopplungsposition mit dem zumindest einen mechanischen Verbindungselement aufweist.

10. Verfahren gemäß Anspruch 9, das ferner folgende Schritte aufweist:
Anordnen der zweiten Membranstruktur (12₂) derart, dass die Elektrodenstruktur (28) zwischen der ersten und der zweiten Membranstruktur (12₁-12₂) angeordnet ist, und
Herstellen des Verstärkungsbereichs der zweiten Membranstruktur (12₂) unter Verwendung eines LOCOS-Prozesses, eines Lokale-Oxidation-von-Silizium-Prozesses, oder unter Verwendung eines Ätzprozesses, um spitz zulaufende Kanten einer Aussparung zu erhalten.

## Revendications

1. Un dispositif MEMS comprenant :
une première structure (12 ; 12₁) de membrane, dans lequel la première structure (12 ; 12₁) de membrane comprend une région (18 ; 18₁ - 18₉) de renfort, dans lequel la région (18 ; 18₁ - 18₉) de renfort a une épaisseur (22₂) de couche plus grande qu'une région (24 ; 24₁ - 24₂) contigüe de la première structure (12 ; 12₁) de membrane, et
une structure (28) d'électrode, dans lequel la structure (28) d'électrode est à distance verticalement de la première structure (12 ; 12₁) de membrane ;
**caractérisé en ce que** :
la première structure (12 ; 12₁) de membrane comprend une région (46 ; 46₁), qui peut être défléchie, et une région de bord serrée, dans lequel la région de bord serrée est contigüe de la région (46 ; 46₁), qui peut être défléchie, le long d'une ligne de bord de la région (46 ; 46₁), qui peut être défléchie, dans lequel la région (18 ; 18₁ - 18₉) de renfort de la première structure (12 ; 12₁) de membrane est disposée à la ligne de bord ; ou
le dispositif MEMS comprend une deuxième structure (12₂) de membrane, dans lequel la structure (28) d'électrode est interposée entre la première et la deuxième structures (12₁ - 12₂) de membrane, dans lequel la première et la deuxième structures (12₁ - 12₂) de membrane comprennent chacune une partie (46₁ - 46₂) pouvant être défléchie, et dans lequel les parties (46₁ - 46₂) pouvant être défléchies de la première et de la deuxième structures (12₁ - 12₂) de membrane sont accouplées mécaniquement au moyen d'au moins un élément (54₁ - 54₃) d'accouplement mécanique l'une à l'autre et sont désaccouplées mécaniquement de la structure (28) d'électrode ; dans lequel au moins l'une de la première et de la deuxième structure (12₁ - 12₂) de membrane comprend une région (18 ; 18₁ - 18₉) de renfort en une position d'accouplement avec le au moins un élément d'accouplement mécanique.

2. Le dispositif MEMS suivant la revendication 1, dans lequel la région (18 ; 18₁ - 18₉) de renfort de la première structure (12 ; 12₁) de membrane est disposée également dans une position alignée par rapport à un bossage (42₁ - 42₃) ou une surélévation disposé sur la structure (28) d'électrode ou à la première structure (12 ; 12₁) de membrane.

3. Le dispositif MEMS suivant la revendication 2, dans lequel le bossage (42₁ - 42₃) ou la surélévation sur la structure (28) d'électrode est orienté vers la première structure (12 ; 12₁) de membrane.

4. Le dispositif MEMS suivant l'une quelconque des revendications précédentes, dans lequel la région (18 ; 18₁ - 18₉) de renfort de la première structure (12 ; 12₁) de membrane est agencée pour comprendre une transition graduelle ou sans degré de l'épaisseur (22₂) de couche à la région (24 ; 24₁ - 24₂) contigüe de la première structure (12 ; 12₁) de membrane.

5. Le dispositif MEMS suivant l'une quelconque des revendications précédentes, dans lequel le dispositif MEMS comprend la deuxième structure (12₂) de membrane, dans lequel la structure (28) d'électrode est interposée entre la première et la deuxième structures (12₁ - 12₂) de membrane, dans lequel les première et deuxième structures (12₁ - 12₂) de membrane comprennent chacune une partie (46₁ - 46₂) pouvant être défléchie, et dans lequel les parties (46₁ - 46₂) pouvant être défléchies des première et deuxième structures (12₁ - 12₂) de membrane sont accouplées mécaniquement au moyen du au moins un élément (54₁ - 54₃) d'accouplement mécanique l'une à l'autre et sont désaccouplées mécaniquement de la structure (28) d'électrode ; dans lequel la deuxième structure (12₂) de membrane comprend une région (18 ; 18₁ - 18₉) de renfort, dans lequel la région (18 ; 18₁ - 18₉) de renfort de la deuxième structure (12₂) de membrane a une épaisseur (22₂) de couche plus grande qu'une région (24 ; 24₁ - 24₂) contigüe de la deuxième structure (12₂) de membrane, et dans lequel la région (18 ; 18₁ - 18₉) de renfort de la deuxième structure (12₂) de membrane est agencée pour comprendre une transition graduelle ou sans degré de l'épaisseur (22₂) de couche à la région (24 ; 24₁ - 24₂) contigüe de la deuxième structure (12₂) de membrane.

6. Le dispositif MEMS suivant l'une quelconque des revendications précédentes, dans lequel le dispositif MEMS comprend la deuxième structure (12₂) de membrane, dans lequel la structure (28) d'électrode est interposée entre les première et deuxième structures (12₁ - 12₂) de membrane, dans lequel les première et deuxième structures (12₁ - 12₂) de membrane comprennent chacune une partie (46₁ - 46₂) pouvant être défléchie, et dans lequel la partie (46₁ - 46₂) pouvant être défléchie des première et deuxième structures (12₁ - 12₂) de membrane sont accouplées mécaniquement au moyen du au moins un élément (54₁ - 54₃) d'accouplement mécanique l'une à l'autre et sont désaccouplées mécaniquement de la structure (28) d'électrode ; dans lequel la région de renfort de la deuxième structure (12₂) de membrane est disposée en une position alignée par rapport à un bossage (44₄ - 44₆) ou une surélévation disposé à la structure (28) d'électrode ou à la deuxième structure (12₂) de membrane.

7. Le dispositif MEMS suivant la revendication 6, dans lequel le bossage ou la surélévation sur la structure (28) d'électrode est orienté vers la deuxième structure (12₂) de membrane.

8. Le dispositif MEMS suivant l'une quelconque des revendications 5 à 7, dans lequel le dispositif MEMS comprend la deuxième structure (12₂) de membrane, dans lequel la structure (28) d'électrode est interposée entre les première et deuxième structures (12₁ - 12₂) de membrane, dans lequel les première et deuxième structures (12₁ - 12₂) de membrane comprennent chacune une partie (46₁ - 46₂) pouvant être défléchie, et dans lequel les parties (46₁ - 46₂) pouvant être défléchies des première et deuxième structures (12₁ - 12₂) de membrane sont accouplées mécaniquement au moyen du au moins un élément (54₁ - 54₃) d'accouplement mécanique l'une à l'autre et sont désaccouplées mécaniquement de la structure (28) d'électrode ; dans lequel la deuxième structure (12₂) de membrane comprend une région (46₂) pouvant être défléchie et une région (48₂) de bord serrée, dans lequel la région (48₂) de bord serrée est contigüe de la région (46₂) pouvant être défléchie le long d'une ligne (52₄) de bord de la région (46₂) pouvant être défléchie, dans lequel la région (18 ; 18₁ - 18₉) de renfort de la deuxième structure (12₂) de membrane est disposée à la ligne (52₄) de bord.

9. Un procédé de fabrication du dispositif MEMS suivant l'une quelconque des revendications précédentes, comprenant fabriquer la région (18 ; 18₁ - 18₉) de renfort de la première structure (12 ; 12₁) de membrane en utilisant un processus LOCOS, processus d'oxydation local du silicium, ou en utilisant un processus d'attaque chimique pour obtenir des bords coniques d'une cavité, et
mettre la structure (28) d'électrode à distance verticalement de la première structure (12 ; 12₁) de membrane ;
**caractérisé en ce que** la première structure (12 ; 12₁) de membrane comprend la région (46 ; 46₁) pouvant être défléchie et la région de bord serrée, **en ce que** la région de bord serrée est contigüe de la région (46 ; 46₁) pouvant être défléchie le long de la ligne de bord de la région (46 ; 46₁) pouvant être défléchie, **en ce que** la région (18 ; 18₁ - 18₉) de renfort de la première structure (12 ; 12₁) de membrane est disposée à la ligne de bord ; ou
**en ce que** le dispositif MEMS comprend la deuxième structure (12₂) de membrane,
dans lequel la structure (28) d'électrode est interposée entre la première et la deuxième structures (12₁ - 12₂) de membrane, de manière à ce que la première et la deuxième structures (12₁ - 12₂) de membrane comprennent chacune la partie (46₁ - 46₂) pouvant être défléchie, et dans lequel les parties (46₁ - 46₂) pouvant être défléchies des première et deuxième structures (12₁ - 12₂) de membrane sont accouplées mécaniquement au moyen du au moins un élément (54₁ - 54₃) d'accouplement mécanique l'une à l'autre et sont désaccouplées mécaniquement de la structure (28) d'électrode ; et **en ce qu'**au moins l'une de la première et de la deuxième structures (12₁ - 12₂) de membrane comprennent la région (18 ; 18₁ - 18₉) de renfort à la position d'accouplement avec le au moins un élément d'accouplement mécanique.

10. Le procédé suivant la revendication 9, comprenant en outre mettre la deuxième structure (12₂) de membrane de telle façon que la structure (28) d'électrode soit interposée entre les première et deuxième structures (12₁ - 12₂) de membrane, et
fabriquer la région de renfort de la deuxième structure (12₂) de membrane en utilisant un processus LOCOS, processus d'oxydation local du silicium, ou en utilisant un processus d'attaque chimique pour obtenir des bords coniques d'une cavité.
